# EUROPÄISCHE PATENTSCHRIFT

(11) **EP 0 588 044 B1**
(45) Veröffentlichungstag und Bekanntmachung des Hinweises auf die Patenterteilung: **10.01.1996**
(21) Anmeldenummer: 93112559.5
(22) Anmeldetag: 05.08.1993
(51) Int. Cl.: C23C 16/48, B01J 19/12, C23C 18/14

(54) **Reaktorvorrichtung**
Reactor apparatus
Appareil réacteur

(30) Priorität: 18.09.1992 DE 4231367
(43) Veröffentlichungstag der Anmeldung: 23.03.1994
(73) Patentinhaber: Heraeus Noblelight GmbH, D-63450 Hanau (DE)
(72) Erfinder: Baier, Michael, D-68309 Mannheim (DE); Brendel, Thomas, D-69198 Schriesheim (DE); Esrom, Hilmar, Dr., D-68535 Edingen-Neckarhausen (DE)
(74) Vertreter: Kühn, Hans-Christian

(56) Entgegenhaltungen:
- WO-A-90/14158
- US-A- 3 769 517
- US-A- 4 002 918

## Beschreibung

Die Erfindung bezieht sich auf eine Reaktorvorrichtung zur Behandlung von festen Werkstoffen, Flüssigkeiten und Gasen.

Eine solche Reaktorvorrichtung wird beispielsweise für die Metallisierung von Bauteilen beliebiger Geometrie eingesetzt, wobei die Metallisierung durch die photolytische Zersetzung einer organischen Metallverbindung mittels UV-Strahlung erfolgt, und die UV-Strahlung durch Excimere erzeugt wird.

Der Erfindung liegt die Aufgabe zugrunde, eine Reaktorvorrichtung aufzuzeigen, die in ihren Abmessungen so gestaltet werden kann, daß sie jederzeit an die Größe und die Geometrie der zu bearbeitenden Bauelemente, Halbzeuge und Rohprodukte angepaßt werden kann.

Diese Aufgabe wird erfindungsgemäß durch die Merkmale des Patentanspruches 1 gelöst.

Erfindungsgemäß wird jede Reaktorvorrichtung aus mehreren Einheiten aufgebaut. Jede dieser Einheiten kann variabel gestaltet werden, und ist selbst in Baureihen gestuft. Zusätzlich können zwei oder mehrere Einheiten lösbar zu einem Model zusammengefaßt werden. Jede Einheit wird mit solchen Anschlußmaßen ausgebildet und derart mit Flanschen versehen, daß sie mit jeder anderen Einheit zusammengebaut werden kann. Damit wird ein Baukastensystem bereitgestellt, mit dem der Bau von verschiedenen Reaktorvarianten im Rahmen der vorhandenen Einheiten möglich ist. Jede Reaktorvorrichtung läßt sich damit problemlos an die Geometrien und Abmessungen der zu be- und verarbeitenden Bauteile und Werkstücke anpassen. Generell weist jede Reaktorvorrichtung eine Lampeneinheit, eine Grundeinheit, eine Beschickungseinheit und eine Ver- und Entsorgungseinheit auf. Die Lampeneinheit dient zur Aufnahme von UV-Hochleistungsstrahlern, deren Anzahl an die Größe der jeweils zu be- und verarbeitenden Bereiche der Bauelemente angepaßt werden kann. In jede Lampeneinheit können UV-Hochleistungsstrahler eingesetzt werden, die als Rundstrahler, Flachstrahler, Kugelstrahler, Topfstrahler, Fingerstrahler, Innenstrahler oder Außenstrahler ausgebildet sind. Zudem sind in der Lampeneinheit Kühlvorrichtungen für die Strahler bzw. die Strahlerelektroden, Blindflansche sowie Reduzierstücke vorgesehen, um Strahler mit variablen Durchmessern und Längen bzw. eine variable Anzahl von Strahlern einsetzen zu können. Strahlerelektroden sind eine Sonderbauform von Strahlern. Sie erlauben es, den Reaktor als offenen Strahler zu betreiben. Die UV-Hochleistungsstrahler sind vorzugsweise auf Halterungen angeordnet, die lösbar in die Lampeneinheit eingebaut sind, so daß sie als fertigmontierte Baugruppe ausgetauscht werden können. Zubehörteile sind Hochfrequenzgeneratoren, Anpassungstransformatoren und Wasserkühler. Die Grundeinheit erlaubt die Erzeugung eines Vakuums, falls es die jeweilige Bearbeitungsform erfordert. Ferner ist mit ihr die Beschickung der Einheit mit Gasen möglich, falls diese benötigt werden. Die Ausbildung eines Vakuums im Inneren einer jeder Reaktorvorrichtung erfolgt durch den Anschluß einer Vakuumpumpe an die Grundeinheit. Zusätzlich sind Meß-, Steuer- und Überwachungsanschlüsse in der Grundeinheit vorgesehen. Die Grundeinheit dient zusätzlich der Aufnahme mindestens einer Positioniervorrichtung. Vorzugsweise ist in jeder Grundeinheit mindestens ein von außen höhenverstellbarer horizontal beweglicher Träger vorgesehen, auf dem das zu bearbeitende Bauelement angeordnet werden kann. Der Träger kann als Tisch, als Klemmtisch oder als Spannvorrichtung ausgebildet sein. Die Beschickungseinheit umfaßt mindestens eine Beschickungsvorrichtung, die garantiert, daß die Beschickung im Durchlauf oder Stapelbetrieb erfolgen kann. Die Beschickungseinheit ist auf zwei gegenüberliegenden Seiten mittels abdichtbaren und/oder sperrbaren Öffnungen versehen, über welche die zu bearbeitenden Bauteile in die Reaktorvorrichtung tranportiert werden. Vorzugsweise weist die Beschickungsvorrichtung Flansche, Manipulatoren, Wendevorrichtungen, Umlenkrollen und Stutzen auf. Zusätzlich kann sie mit Trennscheiben aus Quarz ausgerüstet werden, über die ihr Innenbereich gegen die angrenzenden Einheiten abgetrennt werden kann. Damit ist es möglich, in der Reaktorvorrichtung auch CVD-Verfahren zur Bearbeitung von Oberflächen durchzuführen. Vorzugsweise wird jedoch die Beschichtung eines Bauteils mit einem Überzug, der anschließend in der Reaktorvorrichtung weiterbearbeitet werden soll, mit einem bekannten Verfahren in einer separaten Kammer auf das Bauteil aufgetragen. In der Reaktorvorrichtung kann dieser Überzug dann mittels UV-Strahlung weiterbehandelt, und falls dieses vorgesehen ist, in eine metallische Schicht umgesetzt werden. Es besteht auch die Möglichkeit, die Reaktorvorrichtung mit offenen Strahlern zu betreiben. Neben den obengenannten Einheiten gibt es noch eine Ver- und Entsorgungseinheit. Über diese erfolgt die Entsorgung von Ozon, das bei überkragendem Einbau entsprechender UV-Hochleistungsstrahler an deren Enden in Luft erzeugt wird. Die Ver- und Entsorgungseinheit weist deshalb mindestens eine Absaugvorrichtung auf, über welche dieses Ozon aus der Reaktorvorrichtung entfernt und einem Ozonvernichter zugeleitet werden kann. Sie weist ferner Durchführungen für Leitungen der zum Betrieb der Strahler erforderlichen Spannungsversorgung und Kühlung auf.

Weitere erfindungswesentliche Merkmale sind in den Unteransprüchen gekennzeichnet.

Die Erfindung wird nachfolgend anhand von schematischen Zeichnungen näher erläutert. Es zeigen:
- Figur 1: eine Reaktorvorrichtung in Baukastenform im Vertikalschnitt,
- Figur 2: eine Lampeneinheit,
- Figur 3: eine Variante der in Figur 2 gezeigten Lampen einheit,
- Figur 4: eine weitere Ausführungsform der Lampeneinheit,
- Figur 5: eine Innnenstrahlerbatterie,
- Figur 6: eine Beschickungseinheit,
- Figur 7: eine Variante der in Figur 6 gezeigten Beschikkungseinheit,
- Figur 8: eine weitere Ausführungsform der in Figur 7 dargestellten Beschickungseinheit,
- Figur 9: einen Vertikalschnitt durch eine Grundeinheit,
- Figur 10: eine Variante der in Figur 1 dargestellten Reaktorvorrichtung.

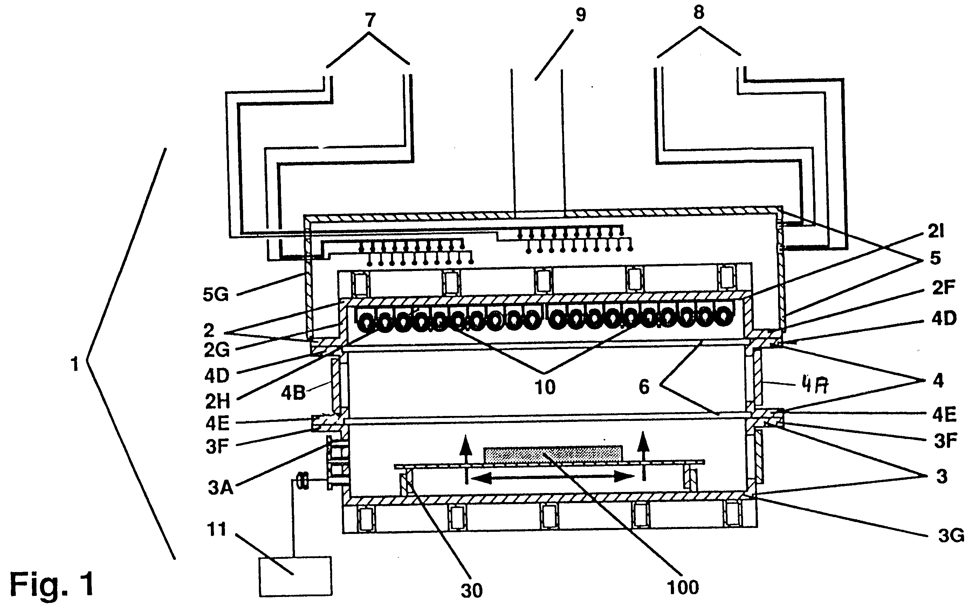

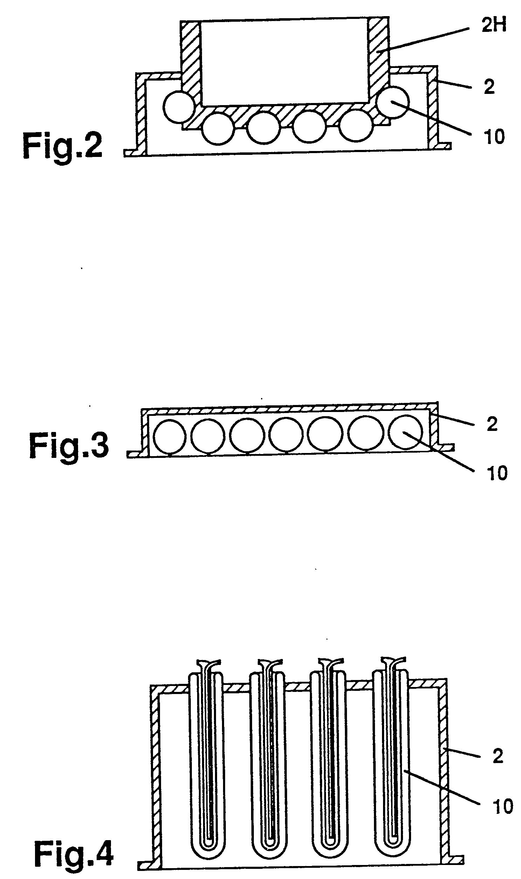

Die in Figur 1 dargestellte Reaktorvorrichtung 1 umfaßt eine Lampeneinheit 2, eine Grundeinheit 3, eine Beschickungseinheit 4 und eine Ver- und Entsorgungseinheit 5. Die Einheiten 2, 3, 4 und 5 sind so ausgebildet, daß sie separat gefertigt und zu der Reaktorvorrichtung 1 zusammensetzbar sind. Die Lampeneinheit 2 weist einen U-förmigen Querschnitt und wird von einem langgestreckten, quaderähnlichen Gehäuse 2G gebildet, das einseitig offen ist. Das Gehäuse 2G ist aus Aluminium oder V2A-Stahl gefertigt. An seiner einzigen großen Innenfläche 2I sind UV-Hochleistungsstrahler 10 derart angeordnet, daß ihre Längsachsen parallel zur Längsachse der Innenfläche 2I verlaufen. Die Hochleistungsstrahler 10 sind lösbar in die Lampeneinheit 2 eingesetzt, und können ihr jederzeit entnommen und durch andere ersetzt werden. Die Lampeneinheit 2 ist an ihren seitlichen Begrenzungsflächen mit nach außen weisenden Flanschen 2F versehen. Diese sind auf die nach außen weisenden Flansche 4D der Beschickungseinheit 4 aufgesetzt. Das Gehäuse 2G der Lampeneinheit 2 ist zu der Beschickungseinheit 4 hin offen. Die ebenfalls quaderähnliche Beschickungseinheit 4 ist aus vier U-Profile zusammengebaut, die aus Aluminium oder V2A-Stahl gefertigt und so angeordnet sind, daß nach außen gerichtete Flansche 4D und 4E gebildet werden. Der Innendurchmesser der Beschickungseinrichtung 4 ist an den Innendurchmesser der Lampeneinheit 2 angepaßt. Die Beschickungseinheit 4 kann zur Lampeneinheit 2 hin offen oder durch Quarzscheiben 6 davon abgetrennt sein. Die Beschickungseinheit 4 ist mit ihren Flanschen 4E auf die nach außen weisenden Flansche 3F der Grundeinheit 3 aufgesetzt. Die Grundeinheit 3 wird von einem quaderähnlichen Gehäuse 3G begrenzt, das ebenso wie das der Lampeneinheit 2 ausgebildet ist. Der Innendurchmesser der Grundeinheit 3 ist an den Innendurchmesser der Beschickungseinheit 4 angepaßt und zu dieser hin offen. Die drei Einheiten 2, 3 und 4 werden über ihre Flansche 2F, 3F, 4D und 4E gasdicht miteinander verbunden. Die Flansche 2F, 3F, 4D und 4E werden nach festgelegten Maßen gefertigt, so daß Einheiten mit gleichen Innendurchmessern immer zusammengebaut werden können. Die Verbindung kann lösbar mittels Schrauben erfolgen. Die Ver- und Entsorgungseinhei 5 hat ebenfalls eine quaderähnliche Form. Sie weist Durchführungen für die elektrische Spannungsversorgungsleitungen 7 und die Zu- und Ableitungen 8 für ein Kühlmedium auf. Diese Leistungen 7 sind für den Betrieb der Hochleistungsstrahler 10 erforderlich. Das die Einheit 5 begrenzende Gehäuse 5G ist aus Plexiglas gefertigt. Wie an Hand von Figur 1 zu sehen ist, sind seine Abmessungen so gewählt, daß es die Lampeneinheit 2 und deren nach außen weisende Flanschen 2F überdeckt, und mit seinen seitlichen Begrenzungsflächen auf den äußeren Rändern der Flansche 2F aufsitzt. Die Ver- und Entsorungseinheit 5 ist zudem mit einer Absaugvorrichtung 9 versehen, die gegebenenfalls an einen Ozonvernichter (hier nicht dargestellt) angeschlossen ist. Auf die Absaugvorrichtung 9 kann verzichtet werden, wenn die UV-Hochleistungsstrahler 10 so angeordnet sind, daß sie nicht das Gehäuse 2G der Lampeneinheit 2 überkragen bwz. keine ozonerzeugenden UV-Hochleistungsstrahler 10 eingesetzt werden. Wie anhand von Figur 2 zu sehen ist, können in der Lampeneinheit 2 UV-Hochleistungsstrahler 10 angeordneten werden, die an einer höhenverstellbaren Haltevorrichtung 2H befestigt sind. Die Haltevorrichtung 2H hat einen U-förmigen Querschnitt. Die UV-Hochleistungsstrahler 10 sind in definiertem Abstand auf der Außenfläche der Haltevorrichtung 2H angeordnet. Die Haltevorrichtung 2H kann auf einfache Weise der Lampeneinheit 2 entnommen und durch eine andere ersetzt werden, auf der beispielsweise auch mehr oder weniger UV-Hochleistungsstrahler 10 angeordnet sein können. Eine Variante der Lampeneinheit zeigt Figur 3. Hierbei sind UV-Hochleistungsstrahler 10, wie in Figur 1 dargestellt, in definiertem Abstand so angeordnet, daß ihre Längsachsen parallel zueinander verlaufen und in einer horizontalen Ebene angeordnet sind. Die Enden der UV-Hochleistungsstrahler 10 überkragen in dieser Ausführugnsform die Wände der Lampeneinheit 2. Bei einer anderen Ausführungsform der Lampeneinheit 2 gemäß Figur 4 sind die UV-Hochleistungsstrahler 10 so anzuordnen, daß ihre Längsachsen in einer vertikalen Ebene in definiertem Abstand parallel zueinander verlaufen. Auch bei dieser Ausführungsform der Lampeneinheit 2 überkragen die Enden der UV-Hochleistungsstrahler 10 das Gehäuse der Lampeneinheit.

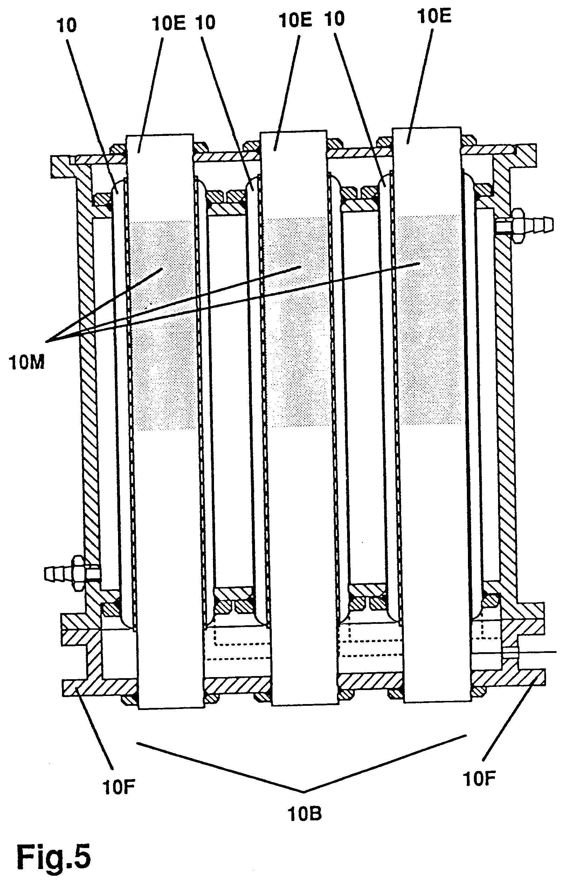

Figur 5 zeigt einen Schnitt durch eine Innenstrahlerbatterie 10B, die hierbei durch drei UV-Hochleistungstrahlern 10 gebildet wird. Die Zahl der Hochleistungsstrahler 10 ist nicht auf drei begrenzt, sondern kann beliebig gewählt werden. Diese UV-Hochleistungsstrahler 10 sind so ausgebildet, daß durch ihren Innenbereich 10E ein strömendes Medium 10M in Form einer Flüssigkeit oder eines Gases geleitet werden kann, das hierbei der Einwirkung von UV- Strahlung ausgesetzt wird.

In gleicher Weise kann auch ein Festkörper (hier nicht dargestellt) mit angepaßten Abmessungen durch die Innenstrahler 10 transportiert und bestrahlt werden. Diese Innenstrahlerbatterie 10B kann als Sonderbauform des Baukastens einzeln benutzt oder über ihre Flansche 10F mit der Beschickungseinheit 4 bzw. der Grundeinheit 3 formschlüssig verbunden werden.

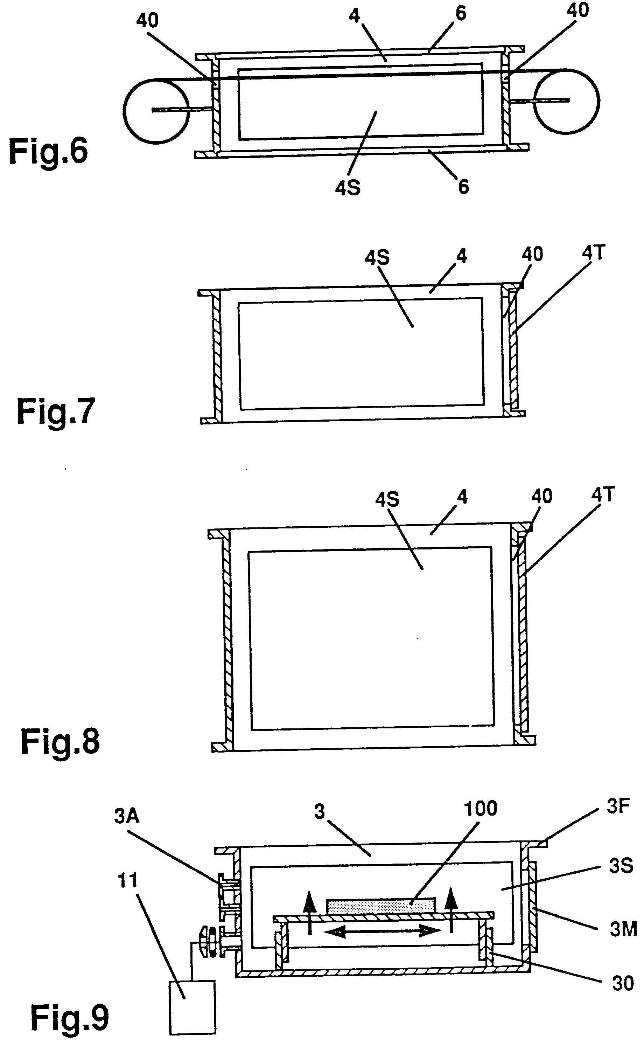

Figur 6 zeigt die mögliche Ausführungsform einer Beschikkungseinheit 4, die für den Durchlaufbetrieb geeignet ist. Die Beschickungseinheit 4 ist auf zwei gegenüberliegenden Seiten mit Öffnungen 4O versehen. Diese können beispielsweise mit Hilfe eines Gases aber auch mechanisch verschlossen oder versperrt werden. Die Beschickungseinheit 4 kann zusätzlich mit Flanschen, Manipulatoren, Wendevorrichtungen, Umlenkrollen, Quarzscheiben und Stutzen versehen werden (hier nicht dargestellt). Die Figuren 7 und 8 zeigen weitere Ausführungsformen der Beschickungseinheit 4 im Vertikalschnitt. Die Beschickungseinheit 4 gemäß Figur 7 weist eine Öffnung 4O auf, die durch eine Tür 4T verschlossen ist. In Figur 8 ist eine Beschickungseinheit 4 dargestellt, die bezüglich ihrer Abmessungen höher als die Einheit 4 gemäß Figur 7 ausgeblidet und mit einem Sichtfenster 4S versehen ist. Hiermit soll die baukastenartige Variabilität der Einheiten 4 veranschaulicht werden, die selbstverständlich auch bei allen anderen Einheiten 2, 3 und 5 gegeben ist.

Figur 9 zeigt die Grundeinheit 3 mit ebenfalls quaderähnlicher Form im Vertikalschnitt Sie ist an eine Vakuumpumpe 11 angeschlossen. Im Inneren befindet sich ein Träger 30, der in der Höhe verstellbar und horizontal beweglich ist. Auf ihm wird das zu bearbeitende Bauelement 100 aufgelegt. Der Träger 30 kann, wie hier gezeigt, als höhenverstellbarer Tisch, als Klemmtisch (hier nicht dargestellt) oder als verschiebbare Spannvorrichtung (hier nicht dargestellt) ausgebildet werden. Der Träger 30 kann bei Bedarf durch die Beschikkungseinheit 4 aus der Grundeinheit 3 entfernt werden. Ferner ist die Grundeinheit 3 mit Anschlußstutzen 3A , Manipulatoren, Blindflanschen, Dichtringen, Flanschen, Thermoelementen, Koaxialkabeldurchführungen, Faltenbalgschläuchen, Ventilen, Verbindungselementen, Druckmeßdosen, Druckanzeigegeräten, Temperaturanzeigegeräten, Photodioden, Meßwertverstärkern und Meßwertschreibern (hier nicht dargestellt) versehen.

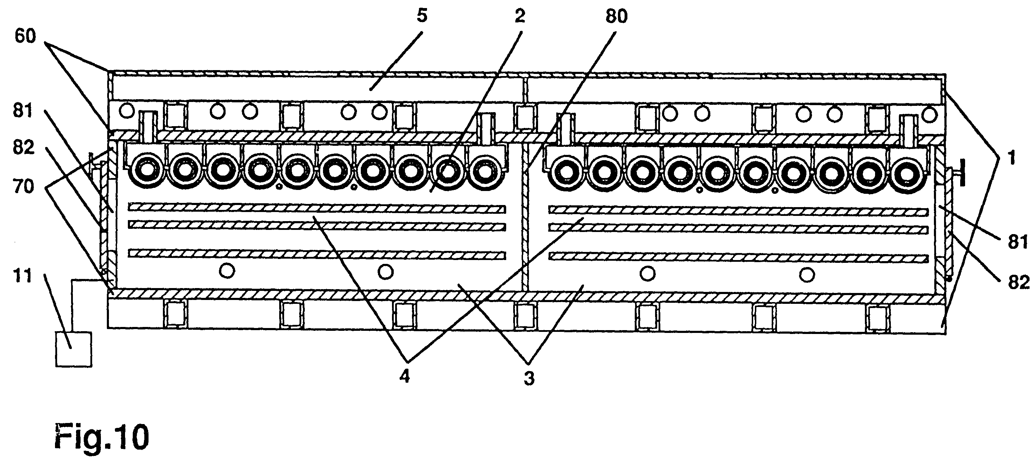

Figur 10 zeigt eine Variante der erfindungsgemäßen Reaktorvorrichtung 1, die aus mehreren Einheiten 2, 3, 4 und 5 zusammengesetzt ist, wobei je eine Einheit 2 und 5 zu einem Modul 60 und je eine Einheit 3 und 4 zu einem Modul 70, zusammengefaßt sind. Wie anhand von Figur 10 zu ersehen ist, weist die Reaktorvorrichtung 1 zwei Module 60 und zwei Module 70 auf. Die beiden Module 60 und die beiden Module 70 sind nebeneinander angeordnet und durch eine Wand 80 voneinander getrennt. Alle Module 60 und 70 sind dauerhaft miteinander verbunden. Durch die Wand 80 wird die Reaktorvorrichtung 1 in zwei Bereiche unterteilt. Hiermit ist eine parallele oder antizyklische Bearbeitung von auf zwei auf Trägern (hier nicht dargestellt) angeordneten Bauelementen möglich. Die Beschickung erfolgt über Öffnungen 81, die an den seitlichen Begrenzungsflächen der Reaktorvorrichtung 1 angeordnet und mit Türen 82 verschlossen sind. Die Erfindung beschränkt sich nicht nur auf die Zusammenfassung der Einheiten zu den hier gezeigten Modulen 60 und 70, sondern umfaßt auch alle anderen für eine Beschichtung geeigneten Kombinationen.

## Patentansprüche

1. Reaktorvorrichtung zur Behandlung von festen Werkstoffen, Flüssigkeiten und Gasen, mit mindestens einer Lampeneinheit (2), einer Grundeinheit (3) zur Erzeugung eines Vakuums, zur Beschickung mit Gasen oder zur Aufnahme von Meß-, Steuer- und Überwachungs- anschlüssen und mindestens einer Positioniervorrichtung, und mit einer Beschikkungseinheit (4) zur Aufnahme einer Beschickungsvorrichtung zur Beschickung im Durchlauf oder Stapelbetrieb, wobei jede Baueinheit (2; 3; 4) mindestens ein Verbindungselement (2F; 3F; 4D; 4E; 10F) aufweist, mittels dem über das Verbindungselement (2F; 3F; 4D; 4E; 10F) mindestens einer benachbarten Baueinheit (2; 3; 4) eine formschlüssige Verbindung herstellbar ist, und, wobei die Reaktorvorrichtung aus mehreren Baueinheiten (2, 3, 4) baukastenartig zusammensetzbar ist.

2. Reaktorvorrichtung nach Anspruch 1, dadurch gekennzeichnet, daß die Verbindungselemente in Form von der Baueinheit (2; 3; 4) nach außen weisender Flansche (2F; 3F; 4D; 4E; 10F) ausgebildet sind.

3. Reaktorvorrichtung nach Anspruch 1 oder 2, dadurch gekennzeichnet, daß sie eine Ver und Entsorgungseinheit (5) zur Entsorgung von Ozon aufweist.

4. Reaktorvorrichtung nach einem der Ansprüche 1 bis 3, dadurch gekennzeichnet, daß die Lampeneinheit (2) mindestens einen UV-Hochleistungsstrahler (10) aufweist, dessen Längsachse in einer horizontalen oder vertikalen Ebene angeordnet ist, und daß wenigstens eine aus der Lampeneinheit entfernbare Halterung (2H) zur Befestigung des UV-Hochleistungsstrahlers (10) vorgesehen ist, oder daß der UV-Hochleistungsstrahler (10) die Gehäusewand (2G) der Lampeneinheit (2) überkragend direkt in die Lampeneinheit (2) eingebaut ist.

5. Reaktorvorrichtung nach einem der Ansprüche 1 bis 4, dadurch gekennzeichnet, daß jede Grundeinheit (3) einen von außen höhenverstellbaren horizontal beweglichen Träger (30) aufweist, der als Tisch, Klemmtisch oder als Schiebevorrichtung ausgebildet ist, und daß mindestens eine Montageklappe, ein Sichtfenster (3S), Flansche (3F) mit vorgegebenen Anschlußmaßen sowie Anschlußstutzen (3A) mit ebenfalls vorgegebenen Abmessungen vorgesehen sind.

6. Reaktorvorrichtung nach einem der Ansprüche 2 bis 5, dadurch gekennzeichnet, daß jede Ver- und Entsorgungseinheit (5) Durchführungen für Spannungsversorgungsleitungen (7), Kühlmittelzu- und -ableitungen (8) sowie eine Abzugvorrichtung (9) aufweist.

7. Reaktorvorrichtung nach Anspruch 2 oder 6, dadurch gekennzeichnet, daß die Gehäuse (2G, 3G und 4G) der Baueinheiten (2, 3 und 4) aus einem korrosionsbeständigen Metall, vorzugsweise V2A-Stahl oder Aluminium gefertigt sind, und daß das Gehäuse (5G) der Versorgungs- und Entsorgungseinheit (5) aus Plexiglas gefertigt ist.

8. Reaktorvorrichtung nach einem der Ansprüche 1 bis 7, dadurch gekennzeichnet, daß jeweils eine Lampeneinheit (2) und eine Versorgungs- und Entsorgungseinheit (5) sowie jeweils eine Grundeinheit (3) und eine Beschickungseinheit (4) zu einem Modul (60, 70) zusammengefaßt sind, und daß zwei oder mehrere Module (60, 70) zu einer Reaktorvorrichtung (1) dauerhaft oder lösbar verbunden und durch jeweils eine Wand (80) so voneinander getrennt sind, und daß eine Beschickung über mit Türen (82) verschließbare Öffnungen (81) an den Seitenflächen der Reaktorvorrichtung (1) vorgesehen ist.

9. Reaktorvorrichtung nach einem der Ansprüche 1 bis 8, dadurch gekennzeichnet, daß zwischen den Einzel-Baueinheiten (2, 3, 4, 5) mindestens jeweils eine Quarzscheibe (6) vorgesehen ist, derart daß die Reaktorvorrichtung (1) als offene Strahlungsvorrichtung nutzbar bzw. die Durchführung von UV-Hochleistungsstrahlung induzierten Gasphasenprozessen sichergestellt ist.

## Claims

1. A reactor device for the treatment of solid materials, liquids and gases, with at least one lamp unit (2), a base unit (3) for the production of a vacuum, for the charging with gases or for the receiving of measurement-, controland monitoring connections and with at least one positioning device and with a charging unit (4) to receive a charging device for charging continuously or in stacking operation, in which each structural unit (2;3;4) has at least one connecting element (2F;3F;4D;4E;10F), by means of which via the connecting element (2F;3F;4D;4E;10F) at least of one adjacent structural unit (2;3;4) a form-fitting connection is able to be produced, and in which the reactor device is able to be composed from several structural units (2,3,4) in the manner of a unitized construction.

2. A reactor device according to Claim 1, characterised in that the connecting elements are constructed in the form of flanges (2F;3F;4D;4E;10F) pointing outwards from the structural unit (2;3;4).

3. A reactor device according to Claim 1 or 2, characterised in that it has a supply- and removal unit (5) for the removal of ozone.

4. A reactor device according to one of Claims 1 to 3, characterised in that the lamp unit (2) has at least one UV high power radiator (10), the longitudinal axis of which is arranged in a horizontal or vertical plane, and that at least one mounting (2H), which is removable from the lamp unit, is provided for the fastening of the UV high power radiator (10), or that the UV high power radiator (10), overhanging the housing wall (2G) of the lamp unit (2), is incorporated directly into the lamp unit (2).

5. A reactor device according to one of Claims 1 to 4, characterised in that each base unit (3) has a horizontally movable carrier (30) which is vertically adjustable from the exterior and which is constructed as a table, clamping table or as a sliding device, and that at least one mounting flap, a viewing window (3S), flanges (3F) with given companion dimensions and also connection pieces (3A) with likewise given dimenions are provided.

6. A reactor device according to one of Claims 2 to 5, characterised in that each supply- and removal unit (5) has ducts for voltage supply lines (7), cooling medium supply and removal lines (8) and also a withdrawal device (9).

7. A reactor device according to Claim 2 or 6, characterised in that the housings (2G, 3G and 4G) of the structural units (2, 3 and 4) are manufactured from a corrosion-resistant metal, preferably V2A steel or aluminium, and that the housing (5G) of the supply- and removal unit (5) is manufactured from plexiglass.

8. A reactor device according to one of Claims 1 to 7, characterised in that in each case a lamp unit (2) and a supply- and removal unit (5) and also in each case a base unit (3) and a charging unit (4) are composed into a module (60,70), and that two or more modules (60,70) are permanently or releasably connected to a reactor device (1), and are separated thus from each other by in each case a wall (80), and that a charging is provided via openings (81), able to be closed by doors (82) on the side faces of the reactor device (1).

9. A reactor device according to one of Claims 1 to 8, characterised in that between the individual structural units (2,3,4,5) at least one quartz sheet (6) is provided in each case, such that the reactor device (1) is able to be used as an open radiation device or the carrying out of gas phase processes induced by UV high power radiation is ensured.

## Revendications

1. Dispositif de réacteur pour le traitement de matières premières solides, de liquides et de gaz, comprenant au moins : une unité de lampes (2), une unité de base (3) pour l'engendrement d'un vide, pour le chargement avec des gaz ou pour l'accueil de raccordements de mesure, de commande et de surveillance et d'au moins un dispositif de positionnement, et une unité de chargement (4) pour l'accueil d'un dispositif de chargement, pour le chargement dans l'exploitation avec défilement traversant ou l'exploitation de piles, chaque unité constitutive (2 ; 3 ; 4) présentant au moins un élément de liaison (2F ; 3F ; 4D ; 4E ; 10F), au moyen duquel, par l'intermédiaire de l'élément de liaison (2F ; 3F ; 4D ; 4E ; 10F), au moins à une unité constitutive voisine (2 ; 3 ; 4), une liaison avec blocage par complémentarité de formes est susceptible d'être réalisée, et le dispositif de réacteur étant susceptible d'être assemblé à partir de plusieurs unités constitutives (2, 3, 4) de façon modulaire.

2. Dispositif de réacteur selon la revendication 1, caractérisé en ce que les éléments de liaison sont constitués sous forme de brides (2F ; 3F ; 4D ; 4E ; 10F) s'orientant vers l'extérieur des unités constitutives (2 ; 3 ; 4).

3. Dispositif de réacteur selon la revendication 1 ou la revendication 2, caractérisé en ce qu'il présente une unité d'alimentation et d'évacuation (5) pour l'évacuation d'ozone.

4. Dispositif de réacteur selon une des revendications 1 à 3, caractérisé en ce que l'unité de lampes (2) présente au moins un émetteur de rayonnement à puissance élevée de UV (10), dont l'axe longitudinal est agencé dans un plan horizontal ou dans un plan vertical, et en ce qu'au moins un dispositif de maintien (2H), susceptible d'être éloigné hors de l'unité de lampes, pour la fixation de l'émetteur de rayonnement à puissance élevée de UV (10), est prévu, ou en ce que l'émetteur de rayonnement à puissance élevée de UV (10), faisant saillie de la paroi de boîtier (2G) de l'unité de lampes (2), est incorporé directement dans l'unité de lampes (2).

5. Dispositif de réacteur selon une des revendications 1 à 4, caractérisé en ce que chaque unité de base (3) présente un support (30) mobile horizontalement, susceptible d'être déplacé en hauteur de l'extérieur, qui est constitué comme table de calage ou comme dispositif de translation, et en ce qu'au moins une trappe de montage, une fenêtre d'observation (3S), des brides (3F) avec des dimensions de raccordement préallouées, ainsi que des tubulures de raccordement (3A) avec également des dimensions préallouées, sont prévues.

6. Dispositif de réacteur selon une des revendications 2 à 5, caractérisé en ce que chaque unité d'alimentation et d'évacuation (5) présente : des passages pour des canalisations de fourniture de tension (7), des canalisations d'amenée et d'évacuation de milieu de refroidissement (8), ainsi qu'un dispositif d'extraction (9).

7. Dispositif de réacteur selon la revendication 2 ou la revendication 6, caractérisé en ce que les boîtiers (2G, 3G et 4G) des unités constitutives (2, 3 et 4) sont fabriqués à partir d'un métal résistant à la corrosion, de façon préférée, de l'acier V2A ou de l'aluminium, et en ce que le boîtier (5G) de l'unité d'alimentation et d'évacuation (5) est fabriqué à partir de plexiglas.

8. Dispositif de réacteur selon une des revendications 1 à 7, caractérisé en ce que, chaque fois, une unité de lampes (2) et une unité d'alimentation et d'évacuation (5), ainsi que, chaque fois, une unité de base (3) et une unité de chargement (4), sont assemblées en un module (60, 70), en ce que deux modules (60, 70) ou plus sont reliés à un dispositif de réacteur (1), en permanence ou susceptibles d'être libérés, et sont séparés, chaque fois, l'un de l'autre par une paroi (80), et en ce qu'un chargement est prévu par l'intermédiaire d'ouvertures (81) susceptibles d'être obturées avec des portes (82), aux faces latérales du dispositif de réacteur (1).

9. Dispositif de réacteur selon une des revendications 1 à 8, caractérisé en ce qu'entre les unités constitutives individuelles (2, 3, 4, 5), chaque fois, au moins une lame de quartz (6) est prévue, de telle sorte que le dispositif de réacteur (1) est susceptible d'être utilisé comme dispositif de rayonnement ouvert, ou bien que l'exécution de processus de phase gazeuse, induits par rayonnement à puissance élevée de UV, est assurée.
